# EUROPEAN PATENT APPLICATION

(11) **EP 2 549 543 A1**
(43) Date of publication of application: **23.01.2013**
(21) Application number: 10847950.2
(22) Date of filing: 31.03.2010
(51) Int. Cl.: H01L 31/04

(54) **SUBSTRATE FOR PHOTOELECTRIC CONVERSION DEVICE, PHOTOELECTRIC CONVERSION DEVICE USING SAME, METHOD FOR PRODUCING THE SUBSTRATE FOR PHOTOELECTRIC CONVERSION DEVICE, AND METHOD FOR MANUFACTURING THE PHOTOELECTRIC CONVERSION DEVICE**

(30) Priority: 15.03.2010 JP 2010057698; 15.03.2010 JP 2010057697
(71) Applicant: Sharp Kabushiki Kaisha, Osaka-shi, Osaka 545-8522 (JP)
(72) Inventor: NASUNO, Yoshiyuki, Osaka 545-8522 (JP); NISHIMURA, Kazuhito, Osaka 545-8522 (JP); TANIMURA, Hiroki, Osaka 545-8522 (JP); KAJIHARA, Kei, Osaka 545-8522 (JP)
(74) Representative: Müller - Hoffmann & Partner
(86) International application number: PCT/JP2010/055931
(87) International publication number: WO 2011/114541

(57) **Abstract**

A photoelectric conversion device (1) includes a substrate (2) and a transparent, electrically conductive film (3) covering at least a portion of a major surface of the substrate (2) and having an irregular geometry on a surface thereof closer to a semiconductor layer. Furthermore, the photoelectric conversion device (1) includes a first conduction type semiconductor layer (5) covering at least a portion of the irregular geometry of the transparent, electrically conductive film (3), and a light absorption layer (6) covering the first conduction type semiconductor layer (5). The irregular geometry has a bump (10) having a maximum height equal to or larger than 50 nm and equal to or smaller than 1200 nm. The bump (10) has a surface having a submicron recess (11) having local peaks (15A, 15B) having a spacing equal to or larger than 2 nm and equal to or smaller than 25 nm. Preferably, the first conduction type semiconductor layer (5) is larger in thickness on a bottom (26) of the submicron recess (11) than at a portion other than the bottom (26). Preferably, the first conduction type semiconductor layer (5) and the light absorption layer (6) have their interface with a maximum depth (Bₘₐₓ) smaller than the submicron recess's maximum depth (Dₘₐₓ).

## Description

### TECHNICAL FIELD

The present invention relates to a substrate for a photoelectric conversion device, the photoelectric conversion device using the substrate, and a method for producing the substrate and the device.

### BACKGROUND ART

A so called super straight type thin film solar cell has a substrate having a major surface at least partially covered with a transparent, electrically conductive film formed of a transparent, electrically conductive material. This transparent, electrically conductive film is covered at least with a first conduction type semiconductor layer and a light absorption layer stacked in layers.

A super straight type thin film silicon based solar cell for example has a p layer (or n layer) which is formed of silicon based thin film as a first conduction type semiconductor layer, an i layer which is formed of silicon based thin film as a light absorption layer, and an n layer (or p layer) which is formed of silicon based thin film as a second conduction type semiconductor layer opposite in conduction type to the first conduction type semiconductor layer, stacked in layers.

A thin film solar cell with a compound semiconductor for example has an n layer which contains CdS as a main component as a first conduction type semiconductor layer, and a p layer which contains CdTe as a main component as a light absorption layer, stacked in layers.

In contrast, a so called sub-straight type thin film solar cell has a substrate having a major surface at least partially covered with a back surface electrode layer, and if necessary, a first conduction type semiconductor layer, a light absorption layer, a second conduction type semiconductor layer, and a transparent, electrically conductive film formed of a transparent, electrically conductive material.

A sub-straight type thin film silicon based solar cell for example has a substrate having a major surface at least partially covered with a back surface electrode layer, and if necessary, a transparent, electrically conductive back surface layer, an n layer (or p layer) which is formed of silicon based thin film as a first conduction type semiconductor layer, an i layer which is formed of silicon based thin film as a light absorption layer, a p layer (or n layer) which is formed of silicon based thin film as a second conduction type semiconductor layer which is opposite in conduction type to the first conduction type semiconductor layer, stacked in layers. A chalcopyrite based thin film solar cell for example has a substrate having a major surface at least partially covered with a back surface electrode layer, a p layer which contains a chalcopyrite based compound (Cu(In, Ga)Se₂, Cu(In, Ga)(Se, S)₂, or CuInS₂) as a main component as a light absorption layer, and if necessary, a buffer layer which contains CdS, CdZnS, or In₂S₃ as a main component, an n layer which contains a zinc compound (ZnO, ZnS (O, OH), Zn (O, S, OH), or Zn (OS)) as a main component as a first conduction type semiconductor layer, and a transparent, electrically conductive film which is formed of ZnO:B, ZnO:Al or indium tin oxide (ITO), stacked in layers.

### SUMMARY OF INVENTION

### TECHNICAL PROBLEM

The present invention contemplates a substrate for a photoelectric conversion device, the photoelectric conversion device using the substrate, and a method for producing the substrate and the device, that can achieve more efficient photoelectric conversion and increased stability.

### SOLUTION TO PROBLEM

A substrate for a photoelectric conversion device according to the present invention includes: a substrate; and a transparent, electrically conductive film covering at least a portion of a major surface of the substrate and having an irregular geometry on a surface thereof facing away from the substrate. The irregular geometry has a bump having a maximum height equal to or larger than 50 nm and equal to or smaller than 1200 nm. The bump has a surface having a submicron recess having local peaks having a spacing equal to or larger than 2 nm and equal to or smaller than 25 nm.

Preferably, the submicron recess has a linear density equal to or larger than 0.05 nm⁻¹.

Preferably, the submicron recess has a maximum depth equal to or larger than 2 nm and equal to or smaller than 10 nm.

A photoelectric conversion device according to the present invention includes: the substrate for the photoelectric conversion device as described above; and a semiconductor layer covering at least a portion of the transparent, electrically conductive film included in the substrate for the photoelectric conversion device.

One form of the photoelectric conversion device according to the present invention includes another semiconductor layer covering the semiconductor layer.

One form of the photoelectric conversion device according to the present invention includes: a first conduction type semiconductor layer having a first conduction type and covering at least a portion of the irregular geometry of the transparent, electrically conductive film; and a light absorption layer covering the first conduction type semiconductor layer. Preferably, the first conduction type semiconductor layer is larger in thickness on a bottom of the submicron recess than at a portion other than the bottom.

One form of the photoelectric conversion device according to the present invention includes: a first conduction type semiconductor layer having a first conduction type and covering at least a portion of the irregular geometry of the transparent, electrically conductive film; and a light absorption layer covering the first conduction type semiconductor layer. Preferably, the first conduction type semiconductor layer and the light absorption layer have their interface with a maximum depth smaller than a maximum depth of the submicron recess.

Preferably, the first conduction type semiconductor layer is equal to or larger than 5 nm and equal to or smaller than 15 nm in thickness.

Preferably, the semiconductor layer is configured of one or more types of thin film selected from the group consisting of silicon based thin film and thin film containing CdTe as a main component.

One form of the photoelectric conversion device according to the present invention includes: a substrate; a back surface electrode layer covering at least a portion of a major surface of the substrate; a light absorption layer covering at least a portion of a major surface of the back surface electrode layer; a first conduction type layer having a first conduction type and covering at least a portion of a major surface of the light absorption layer; and a transparent, electrically conductive film covering at least a portion of a major surface of the first conduction type layer and having an irregular geometry on a side thereof opposite to the first conduction type layer. The irregular geometry has a bump having a maximum height equal to or larger than 50 nm and equal to or smaller than 1200 nm, and the bump has a surface having a submicron recess having local peaks having a spacing equal to or larger than 2 nm and equal to or smaller than 25 nm.

Preferably, the semiconductor layer is configured of one or more types of thin film selected from the group consisting of silicon based thin film and thin film containing a chalcopyrite based compound as a main component.

One form of the photoelectric conversion device according to the present invention includes: a substrate; a back surface electrode layer covering at least a portion of a major surface of the substrate; a light absorption layer covering at least a portion of a major surface of the back surface electrode layer; and a first conduction type layer having a first conduction type and covering at least a portion of a major surface of the light absorption layer. The first conduction type layer has an irregular geometry on a side thereof opposite to the light absorption layer. The irregular geometry has a bump having a maximum height equal to or larger than 50 nm and equal to or smaller than 1200 nm. The bump has a surface having a submicron recess having local peaks having a spacing equal to or larger than 2 nm and equal to or smaller than 25 nm.

A method for producing a substrate for a photoelectric conversion device according to the present invention includes the steps of: depositing a transparent, electrically conductive film to cover at least a portion of a major surface of a substrate, the transparent, electrically conductive film having an irregular geometry having a bump having a maximum height equal to or larger than 50 nm and equal to or smaller than 1200 nm; and exposing the transparent, electrically conductive film to a hydrogen containing plasma.

Preferably, the hydrogen containing plasma employs a gas formed substantially only of gaseous hydrogen.

The method for producing a photoelectric conversion device according to the present invention preferably includes the step of forming on a surface of the bump a submicron recess having local peaks having a spacing equal to or larger than 2 nm and equal to or smaller than 25 nm.

The method for producing a substrate for a photoelectric conversion device according to the present invention preferably includes the step of introducing a defect in a surface of the transparent, electrically conductive film between the step of depositing the transparent, electrically conductive film and the step of forming the submicron recess.

One form of the method for producing a substrate for a photoelectric conversion device according to the present invention employs a carbon containing hydrogen plasma in the step of forming the submicron recess.

A method for producing a photoelectric conversion device according to the present invention includes the step of depositing a semiconductor layer to cover at least a portion of the transparent, electrically conductive film included in the substrate for the photoelectric conversion device as described above.

One form of the method for producing a photoelectric conversion device according to the present invention includes the steps of: depositing a first conduction type semiconductor layer to cover at least a portion of the transparent, electrically conductive film; and depositing a light absorption layer to cover the first conduction type semiconductor layer. Preferably in the step of depositing the first conduction type semiconductor layer the first conduction type semiconductor layer is formed to be larger in thickness on a bottom of the submicron recess than at a portion other than the bottom.

In the method for producing a photoelectric conversion device according to the present invention preferably the submicron recess is formed to have a maximum depth equal to or larger than 2 nm and equal to or smaller than 10 nm.

In the method for producing a photoelectric conversion device according to the present invention preferably the submicron recess is formed to have a linear density equal to or larger than 0.05 nm⁻¹.

### ADVANTAGEOUS EFFECTS OF INVENTION

Providing submicron recesses allows a photoelectric conversion device to achieve more efficient photoelectric conversion and increased stability.

### BRIEF DESCRIPTION OF DRAWINGS

Fig. 1 is a cross section schematically showing a configuration of a photoelectric conversion device according to one embodiment of the present invention.
Fig. 2 is a cross section schematically showing a configuration of a photoelectric conversion device which has two photoelectric conversion layers according to a first exemplary variation of the embodiment.
Fig. 3 is a cross section schematically showing a configuration of a photoelectric conversion device which has three photoelectric conversion layers according to a second exemplary variation of the embodiment.
Fig. 4 is an image, as obtained with a TEM, of a portion in cross section of the photoelectric conversion device according to the embodiment.
Fig. 5 is the Fig. 4 image with each pixel having a brightness value binarized with a threshold value of 50%.
Fig. 6 is a schematic representation of the Fig. 5 image.
Fig. 7 is an image, as obtained with a TEM, of a vicinity of a boundary of a bump of a transparent, electrically conductive film and a p layer and an i layer according to the embodiment.
Fig. 8 is the Fig. 7 image with each pixel having a brightness value binarized with a threshold value of 50%.
Fig. 9 is a schematic representation of the Fig. 8 image.
Fig. 10 shows the Fig. 8 image as analyzed in accordance with rolling circle waviness measurement.
Fig. 11 is a schematic diagram showing a submicron recess and a rolling circle.
Fig. 12 illustrates a maximum depth of submicron recesses.
Fig. 13 illustrates a maximum depth of an interface of a p layer and an i layer.
Fig. 14 illustrates the p layer's thickness.
Fig. 15 plots spectral transmittance and spectral reflectance for each of a substrate for the photoelectric conversion device of the present embodiment, a substrate for a photoelectric conversion device which does not have submicron recesses, and a substrate for a photoelectric conversion device having undergone an intense hydrogen plasma treatment.
Fig. 16A is a cross section schematically showing how light propagates in the photoelectric conversion device which is not provided with submicron recesses.
Fig. 16B is a cross section schematically showing how light propagates in the photoelectric conversion device of the embodiment.
Fig. 17 is a graph which shows how a characteristic value of a TCO substrate varies with the intensity of a hydrogen containing plasma treatment.
Fig. 18A schematically illustrates a first stage of a chemical reaction in a mixed-plasma treatment at a portion of the TCO substrate other than the submicron recesses.
Fig. 18B schematically illustrates a second stage of the chemical reaction in the mixed-plasma treatment at the portion of the TCO substrate other than the submicron recesses.
Fig. 18C schematically illustrates a third stage of the chemical reaction in the mixed-plasma treatment at the portion of the TCO substrate other than the submicron recesses.
Fig. 19A schematically illustrates a first stage of a chemical reaction in the mixed-plasma treatment at a submicron recess of the TCO substrate.
Fig. 19B schematically illustrates a second stage of the chemical reaction in the mixed-plasma treatment at the submicron recess of the TCO substrate.
Fig. 19C schematically illustrates a third stage of the chemical reaction in the mixed-plasma treatment at the submicron recess of the TCO substrate.
Fig. 20A is a schematic diagram showing an interface of a p layer and an i layer in a hypothetical photoelectric conversion device.
Fig. 20B is a schematic diagram showing an interface of a p layer and an i layer in a conventional photoelectric conversion device.
Fig. 20C is a schematic diagram showing an interface of a p layer and an i layer in the photoelectric conversion device of the embodiment.
Fig. 21 A schematically illustrates a first stage of a chemical reaction at a portion of the TCO substrate other than the submicron recesses.
Fig. 21B schematically illustrates a second stage of the chemical reaction at the portion of the TCO substrate other than the submicron recesses.
Fig. 21C schematically illustrates a third stage of the chemical reaction at the portion of the TCO substrate other than the submicron recesses.
Fig. 22A schematically illustrates a first stage of a chemical reaction at a submicron recess of the TCO substrate.
Fig. 22B schematically illustrates a second stage of the chemical reaction at the submicron recess of the TCO substrate.
Fig. 22C schematically illustrates a third stage of the chemical reaction at the submicron recess of the TCO substrate.
Fig. 22D schematically illustrates a fourth stage of the chemical reaction at the submicron recess of the TCO substrate.
Fig. 23 is a cross section showing a structure of a sub-straight type thin film solar cell with the present invention applied thereto.
Fig. 24 is a cross section showing a structure of a chalcopyrite based thin film solar cell with the present invention applied thereto.

### DESCRIPTION OF EMBODIMENTS

The present invention provides a substrate for a photoelectric conversion device, a photoelectric conversion device with the substrate, and a method for producing the substrate and the device in one embodiment, as will be described hereinafter with reference to the drawings. In describing the following embodiments, identical or corresponding components are identically denoted and will not be described repeatedly in detail.

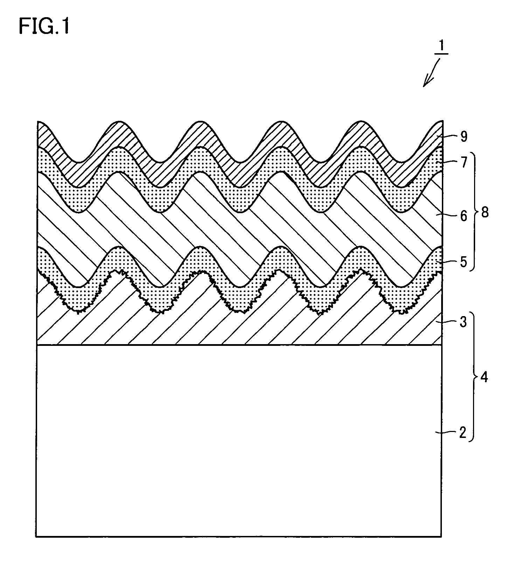

Fig. 1 is a cross section schematically showing a configuration of a photoelectric conversion device according to one embodiment of the present invention. As shown in Fig. 1, the present embodiment provides a photoelectric conversion device 1 having a substrate that is a glass substrate 2, and a transparent, electrically conductive film 3 deposited on an upper surface of the substrate, and containing tin oxide (SnO₂) as a main component and having an irregular geometry.

While the present embodiment employs a substrate that is a glass substrate, it may be any substrate that can transmit the light converted in photoelectric conversion device 1, and preferably, it is a substrate that can be used for a super straight type solar cell. The super straight type solar cell refers to a solar cell receiving light at the substrate's side. For example, the substrate can be formed of a material which has a thermal resistance to endure a plasma chemical vapor deposition (plasma CVD) process and is also transparent. Specifically, the substrate can be formed of glass, polyimide, or the like, and may be formed for example of alkali-free glass.

Glass substrate 2 and transparent, electrically conductive film 3 configure a substrate 4 for a photoelectric conversion device. Transparent, electrically conductive film 3 can be formed with ITO, zinc oxide (ZnO) or the like, and may for example be SnO₂ film.

In the present embodiment, substrate 4 for a photoelectric conversion device may have another layer formed between a substrate in the form of a plate, such as glass substrate 2, and transparent, electrically conductive film 3. For example, a silicon oxide film or a similar layer may be formed that prevents alkali metal impurity contained in glass substrate 2 from diffusing into transparent, electrically conductive film 3.

While in the present embodiment substrate 4 for the photoelectric conversion device has glass substrate 2 with one major surface having a large portion covered with transparent, electrically conductive film 3, glass substrate 2 may have the major surface partially uncovered with transparent, electrically conductive film 3.

Such a substrate is obtained for example by placing glass substrate 2 in a tray in the form of a frame and then depositing transparent, electrically conductive film 3 by sputtering or the like. In that case, transparent, electrically conductive film 3 is not deposited on a peripheral portion of the major surface that is behind the tray. Alternatively, transparent, electrically conductive film 3 may be deposited throughout one major surface of the substrate, and a subsequent step may then be performed to trim away transparent, electrically conductive film 3 that is located at the peripheral portion of the major surface. Specifically, the film may be trimmed away by laser-trimming, sandblasting, mechanical polishing, or the like. Furthermore, a substrate having transparent, electrically conductive film 3 partially laser-scribed or the like and thus divided into a plurality of portions is also included as the substrate for the photoelectric conversion device of the present embodiment.

Deposited on an upper surface of transparent, electrically conductive film 3 is a p layer 5, which serves as a p type, first conduction type semiconductor layer and is formed of a-SiC:H:B. P layer 5 may be configured of a-Si:H:B, a-SiN:H:B, or a film thereof stacked in layers.

Deposited on an upper surface of p layer 5 is an i layer 6 which is substantially formed of a-Si:H and serves as a substantially i type semiconductor layer. Note that herein "substantially i type" means not only completely i type but also weak p type or weak n type. Hereinafter, they will also be referred to as "substantially i type" or simply "i type".

For improved interface characteristics, preferably, a so called buffer layer is provided in a vicinity of an interface of i layer 6 and first or second conduction type semiconductor layer. For example, if p layer 5 is formed of a-SiC:H:B, the buffer layer can be a layer which has a composition having a higher ratio of silicon and carbon at a side closer to the interface with p layer 5 and a lower ratio of carbon toward and into the bulk of i layer 6. Hereinafter, the "i layer" will be referred to as also including such a substantially undoped buffer layer.

Deposited on an upper surface of i layer 6 is an n layer 7 which is formed of a-Si:H:P and serves as an n type, second conduction type semiconductor layer. N layer 7 may be configured of a-SiN:H:B, µc-Si:H:P, µc-SiN:H:P, or a film thereof stacked in layers. Herein "µc" means microcrystal, i.e., crystal grains and an amorphous component that are intermingled. P layer 5, i layer 6, and n layer 7 configure a photoelectric conversion layer 8. Photoelectric conversion layer 8 is formed of a pin junction of crystalline and/or amorphous layers. Herein, being "crystalline" also means being so called microcrystalline.

Furthermore, while the photoelectric conversion device of the present embodiment has glass substrate 2 with one major surface having a large portion covered with a semiconductor layer, glass substrate 2 may have the major surface partially uncovered with the semiconductor layer.

Such a substrate is obtained for example by placing a substrate for the photoelectric conversion device in a tray in the form of a frame and then depositing the semiconductor layer by plasma CVD or the like. In that case, the semiconductor layer is not deposited on a peripheral portion of the major surface that is behind the tray. Alternatively, the semiconductor layer may be deposited throughout one major surface of the substrate, and a subsequent step may then be performed to trim away the semiconductor layer that is located at the peripheral portion of the major surface. Specifically, the layer may be trimmed away by laser-trimming, sandblasting, mechanical polishing, or the like. Furthermore, a photoelectric conversion device having the semiconductor layer partially laser-scribed or the like and thus divided into a plurality of portions is also included as the photoelectric conversion device of the present embodiment.

The present photoelectric conversion device may be a plurality of photoelectric conversion layers that are stacked in layers. Accordingly, the photoelectric conversion layers can be any of device structures of a single pin junction, two junctions of top layer pin/bottom layer pin, three junctions of top layer pin/middle layer pin/bottom layer pin, and four or more junctions. Note that a "pin junction" also includes that in which the i layer has a so called buffer layer in a vicinity of its interface with at least one of the p layer and the n layer.

Preferably the plurality of photoelectric conversion layers have their respective substantially i type semiconductor layers with their respective band gaps different from one another for more efficient photoelectric conversion. Specifically, for example, an i-type semiconductor layer of hydrogenated amorphous silicon and an i-type semiconductor layer of hydrogenated microcrystalline silicon are preferably combined. Alternatively, the i type semiconductor layers may have compositions having different ratios, respectively, of silicon to hydrogen, carbon, germanium and other elements.

If a plurality of photoelectric conversion layers are stacked in layers, a transparent, electrically conductive layer may be provided between adjacent photoelectric conversion layers. The transparent, electrically conductive layer can for example be of ZnO and SiOₓ or other similar, transparent, electrically conductive oxide film, or can be of a-Si:N:H, µc-Si:N:H or other similar silicon nitride film.

Deposited on an upper surface of n layer 7 are a transparent, electrically conductive back surface film (not shown) which contains ZnO as a main component, and a back surface electrode layer 9 which contains silver as a main component. While in the present embodiment the transparent, electrically conductive back surface film is formed of ZnO, it may be formed of any material that is transparent and electrically conductive, and it may be ITO or the like. While in the present embodiment back surface electrode layer 9 is formed of silver, it may be formed of any material that is electrically conductive, and it may be formed for example of A1 or other material.

Furthermore while the photoelectric conversion device of the present embodiment has glass substrate 2 with one major surface having a large portion covered with back surface electrode layer 9, glass substrate 2 may have the major surface partially uncovered with back surface electrode layer 9.

Such a substrate is obtained for example by placing substrate 4 for the photoelectric conversion device in a tray in the form of a frame and then depositing back surface electrode layer 9 by sputtering. In that case, back surface electrode layer 9 is not deposited on a peripheral portion of the major surface that is behind the tray. Alternatively, back surface electrode layer 9 may be deposited throughout one major surface of the substrate, and a subsequent step may then be performed to trim away back surface electrode layer 9 that is located at the peripheral portion of the major surface. Specifically, the layer may be trimmed away by laser-trimming, sandblasting, mechanical polishing, or the like. The transparent, electrically conductive film, the semiconductor layer, the transparent, electrically conductive back surface film, and the back surface electrode layer that are stacked in layers can also be subjected to a single step so that a plurality of layers can be trimmed away all at once. Furthermore, a photoelectric conversion device having back surface electrode layer 9 partially laser-scribed or the like and thus divided into a plurality of portions is also included as the photoelectric conversion device of the present embodiment.

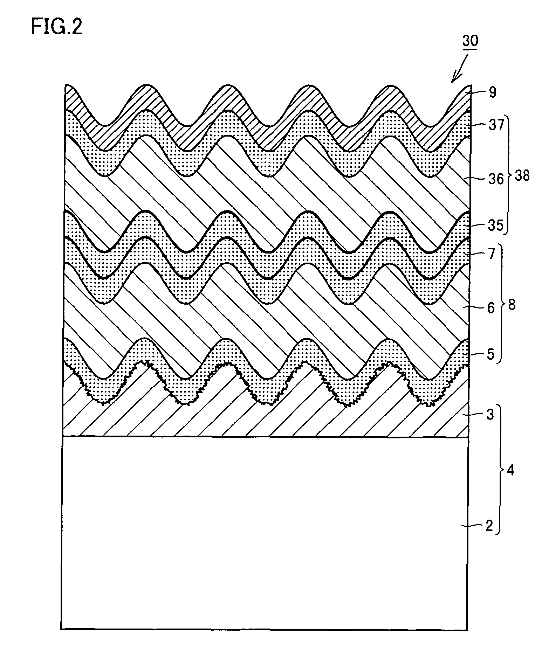

Fig. 2 is a cross section schematically showing a configuration of a photoelectric conversion device which has two photoelectric conversion layers according to the present embodiment in one exemplary variation. As shown in Fig. 2, the present embodiment in one exemplary variation provides a photoelectric conversion device 30 having on photoelectric conversion layer 8 a photoelectric conversion layer 38 including a p layer 35, an i layer 36, and an n layer 37 stacked in layers.

First photoelectric conversion layer 8 has i layer 6 containing a-Si:H (hydrogenated amorphous silicon) as a main component. Second photoelectric conversion layer 38 has i layer 36 containing µc-Si:H (hydrogenated microcrystalline silicon) as a main component. Photoelectric conversion device 30 is a photoelectric conversion device of a so called tandem construction having substrate 4 for the photoelectric conversion device, first photoelectric conversion layer 8, and second photoelectric conversion layer 38 stacked in layers.

The first photoelectric conversion layer, serving as a top layer, can be configured with p layer 5 implemented for example as a hydrogenated amorphous silicon carbide (a-SiC:H:B) layer, a hydrogenated amorphous silicon (a-Si:H:B) layer, a hydrogenated amorphous silicon nitride (a-SiN:H:B) layer, or a stack thereof. Preferably, p layer 5 is 5 nm to 30 nm in thickness.

The top layer can be configured with i layer 6 implemented for example as an a-Si:H layer. Preferably, i layer 6 is 100 nm to 400 nm in thickness.

The top layer can be configured with n layer 7 implemented for example as an a-Si:H:P layer, an a-Si:N:H:P layer, a hydrogenated microcrystalline silicon (µc-Si:H:P) layer, a hydrogenated microcrystalline silicon nitride (µc-Si:N:H:P) layer, or a stack thereof. Preferably, n layer 7 is 5 nm to 40 nm in thickness.

The second photoelectric conversion layer, serving as a bottom layer, can be configured with p layer 35 implemented for example as a µc-Si:H:B layer, a microcrystalline silicon nitride (µc-SiN:H:B) layer, a hydrogenated microcrystalline silicon carbide (µc-SiC:H:B) layer, or a stack thereof. Preferably, p layer 35 is 5 nm to 30 nm in thickness.

The bottom layer can be configured with i layer 36 implemented for example as a µc-Si:H layer. Preferably, i layer 36 is 1000 nm to 3000 nm in thickness.

The bottom layer can be configured with n layer 37 implemented for example as an a-Si:H:P layer, an a-Si:N:H:P layer, a hydrogenated microcrystalline silicon (µc-Si:H:P) layer, a hydrogenated microcrystalline silicon nitride (µc-Si:N:H:P) layer, or a stack thereof. Preferably, n layer 37 is 5 nm to 40 nm in thickness.

Preferably, an n type, hydrogenated microcrystalline silicon (µc-Si:H:P) layer is posed between the top layer's constituent n layer and the bottom layer's constituent p layer.

The transparent, electrically conductive back surface film can for example be ZnO film. Preferably, the transparent, electrically conductive back surface film is 20 nm to 150 nm in thickness. Back surface electrode layer 9 can for example be Ag film or Al film. Preferably, back surface electrode layer 9 is 50 nm to 500 nm in thickness.

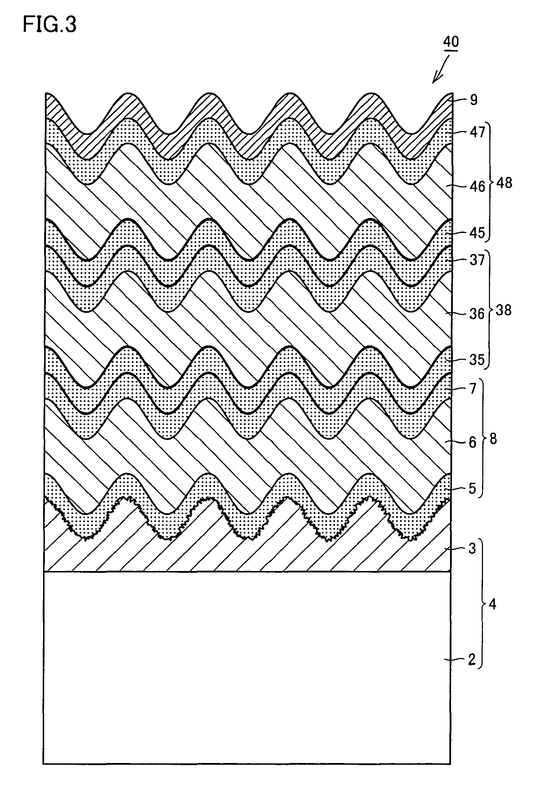

Fig. 3 is a cross section schematically showing a configuration of a photoelectric conversion device which has three photoelectric conversion layers according to the present embodiment in a second exemplary variation. As shown in Fig. 3, the present embodiment in the second exemplary variation provides a photoelectric conversion device 40 having a 3-junction tandem construction that has on photoelectric conversion layer 8 photoelectric conversion layer 38 including p layer 35, i layer 36 and n layer 37 stacked in layers and has on photoelectric conversion layer 38 a photoelectric conversion layer 48 including a p layer 45, an i layer 46 and an n layer 47 stacked in layers.

In this case, first photoelectric conversion layer 8, second photoelectric conversion layer 38, and third photoelectric conversion layer 48 may have their respective i layers 6, 36, and 46 in a so called triple structure such as a-Si:H/a-Si:H/µc-Si:H, a-Si:H/a-SiGe:H/µc-Si:H, a-Si:H/a-Si:H/µc-SiGe:H, a-Si:H/a-SiGe:H/µc-SiGe:H, and a-Si/µc-Si/µc-Si. The other layers may be formed of material similar to that used in the single junction type or 2-junction type photoelectric conversion device.

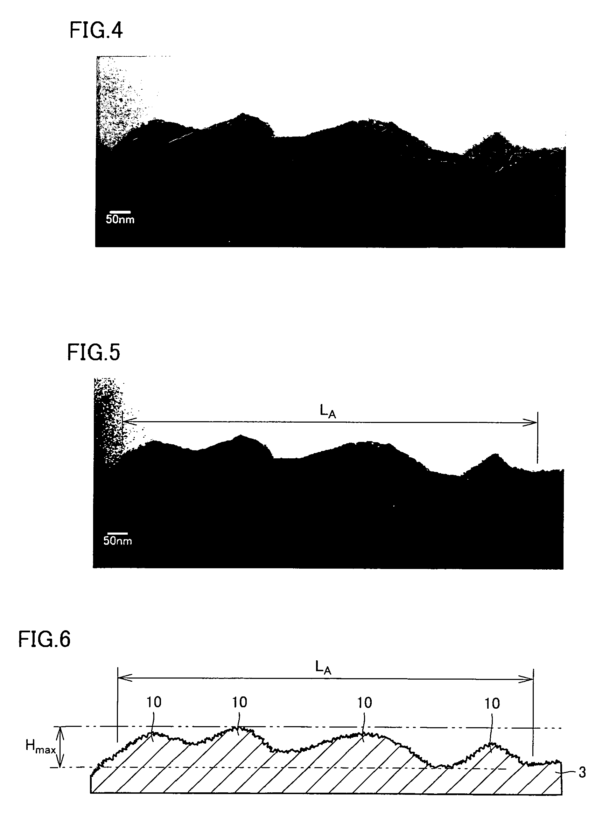

Fig. 4 is an image, as obtained with a transmission electron microscope (TEM), of a portion in cross section of the photoelectric conversion device according to the embodiment. The Fig. 4 image shows a vicinity of a boundary of substrate 4 for the photoelectric conversion device and photoelectric conversion layer 8.

Fig. 5 is the Fig. 4 image with each pixel having a brightness value binarized with a threshold value of 50%. Herein, binarization is a process done to an image to make white any pixel thereof having a brightness value equal to or larger than a threshold value and make black any pixel thereof having a brightness value smaller than the threshold value. When a brightness value for white is represented as 255 and that for black is represented as 0, and the threshold value is set at 50%, then, any pixel having a brightness value of 128 or larger is converted into white, whereas any pixel having a brightness value smaller than 128 is converted into black. Note that the threshold value can be appropriately selected so that a white region and a black region may be divided at the interface of transparent, electrically conductive film 3 and photoelectric conversion layer 8.

Fig. 6 is a schematic representation of the Fig. 5 image. As shown in Fig. 6, transparent, electrically conductive film 3 formed on the upper surface of glass substrate 2 has a plurality of bumps 10. Herein, a length of 1000 nm parallel to the major surface of glass substrate 2 is set as a reference length (L_{A}). Within the range of reference length (L_{A}), a plurality of bumps 10 form ridges and troughs, of which the highest ridge and the lowest trough define therebetween a maximum distance in height (Hₘₐₓ).

In the Fig. 5 case, four bumps 10 are observed within the range of reference length (L_{A}) of 1000 nm. Of four bumps 10, the second ridge from the left is the highest and the second trough from the right is the lowest. In the Fig. 5 case, bump 10 has a maximum height of 100 nm.

Note that, in the Fig. 4 image, the interface of transparent, electrically conductive film 3 and glass substrate 2 is not observed. Accordingly, in order to determine the direction of reference length (L_{A}), initially in the TEM observation a low magnification is set to allow the interface of the major surface of glass substrate 2 and transparent, electrically conductive film 3 to be observed to obtain an image having a horizontal direction parallel to the interface of transparent, electrically conductive film 3 and glass substrate 2. Thereafter, as shown in Fig. 4, the magnification is raised to an extent so that the maximum height of bump 10 is observable, and the direction of reference length (L_{A}) is set parallel to the image's horizontal direction.

Preferably, bump 10 has a dimension allowing light to be scattered or reflected to be suitable for a light absorption characteristic of photoelectric conversion layer 8. For example, bump 10 having a dimension that can cause a sufficient light scattering effect not only for a wavelength at a center of solar light spectra, more specifically, a medium wavelength of approximately 450-650 nm, but also a long wavelength of approximately 700-1200 nm, is preferable. Accordingly, bump 10 preferably has a maximum height equal to or larger than 50 nm and equal to or smaller than 1200 nm.

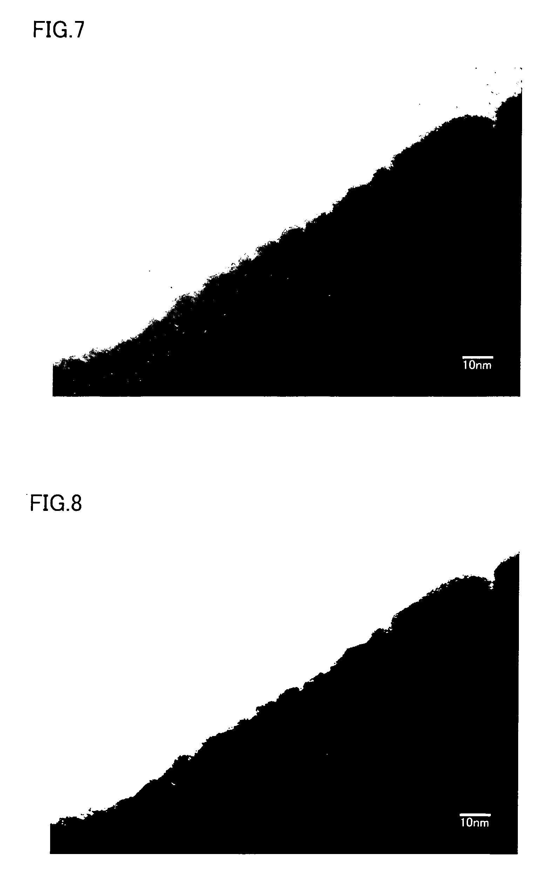

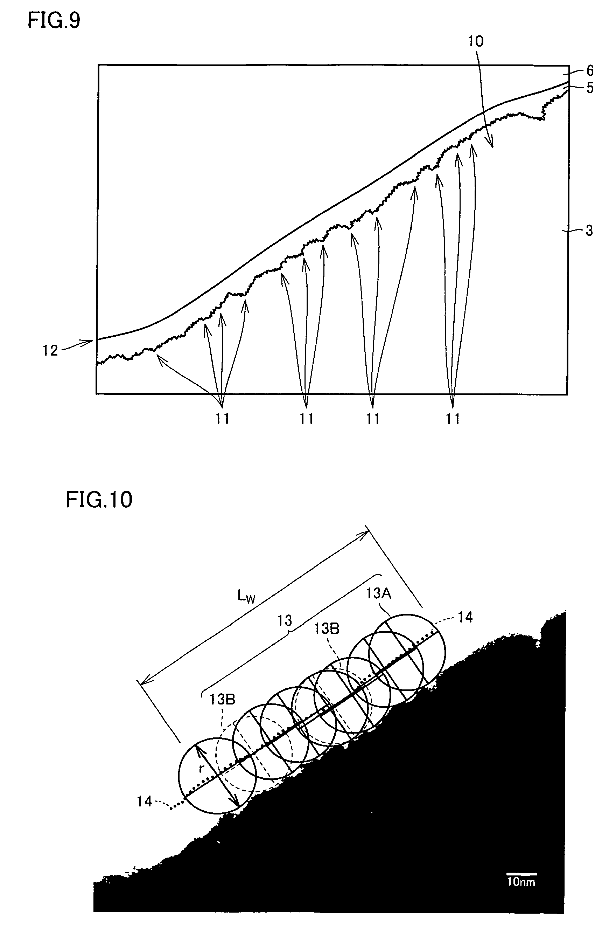

Fig. 7 is an image, as obtained with a TEM, of a vicinity of a boundary of a bump of a transparent, electrically conductive film and a p layer and an i layer according to the embodiment. Fig. 8 is the Fig. 7 image with each pixel having a brightness value binarized with a threshold value of 50%. Fig. 9 is a schematic representation of the Fig. 8 image.

As shown in Fig. 9, transparent, electrically conductive film 3 has bump 10 with a surface having a plurality of submicron recesses 11. Furthermore, p layer 5 and i layer 6 having a buffer layer in a vicinity of its interface with p layer 5 have an interface 12 therebetween extending in a gentle line generally parallel to the surface of transparent, electrically conductive film 3.

In accordance with the present invention, the submicron recess and its linear density and maximum depth are defined, as will be described hereinafter.

Fig. 10 shows the Fig. 8 image as analyzed in accordance with rolling circle waviness measurement. Hereinafter, a line shown in Fig. 10 representing a surface of bump 10 of transparent, electrically conductive film 3 (i.e., a boundary line between a white portion and a black portion) will be referred to as a measurement cross section line.

When a rolling circle 13 of 25 nm in diameter rolls along the measurement cross section line, the center 14 of rolling circle 13 provides a locus, which will be referred to as a rolling circle traced profile. In the present embodiment, a reference length (L_{w}) of 80 nm is set. A rolling circle traced profile measured for the reference length is subjected to least squares using a linear function (a straight line) to calculate an average line of the rolling circle traced profile. Hereinafter, the average line of the rolling circle traced profile will be referred to as a measured average line.

Note that when the above rolling circle waviness measurement is compared with a measurement condition of the Japanese Industrial Standards (JIS) (JIS B0610:'01), the former has a ratio of the radius of the rolling circle and the reference length that is twice that of the latter.

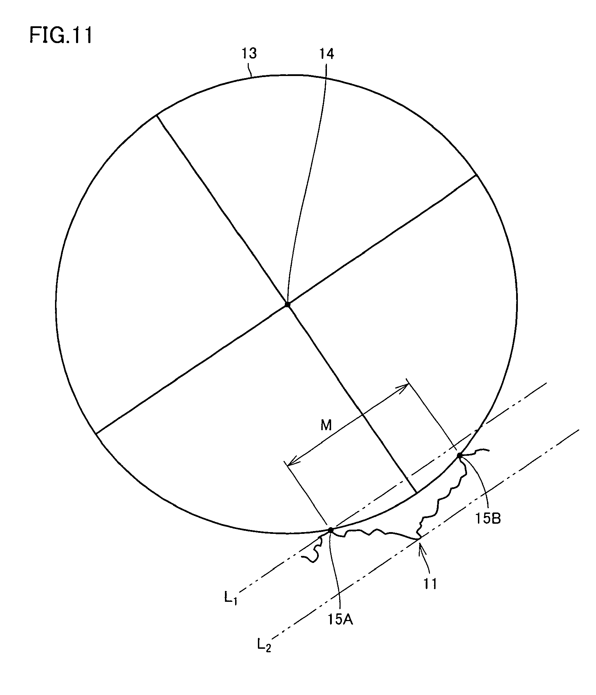

Fig. 11 is a schematic diagram showing a submicron recess and a rolling circle. As shown in Fig. 11, rolling circle 13 is in contact with submicron recess 11 at at least two points. Of these contact points, the two contact points that are the most spaced contact points will be referred to as local peaks 15A and 15B.

Of lines parallel to the measured average line, the line that passes through the bottom of submicron recess 11 will be referred to as a base line (L₂). Of the line that is parallel to the measured average line and passes through local peak 15A and the line that is parallel to the measured average line and passes through local peak 15B, the line that is remoter from base line (L₂) will be referred to as a summit line (L₁).

Submicron recess 11 indicates a recess having a depth, or a distance between base line (L₂) and summit line (L₁), equal to or larger than 1 nm, and a width, or a distance M between two local peaks 15A and 15B, equal to or larger than 2 nm.

In Fig. 10, a solid line represents a rolling circle 13A which is in contact with submicron recesses 11 which satisfy the above conditions for the range of reference length (L_{w}) of 80 nm, and a broken line represents a rolling circle 13B which is in contact with recesses which do not satisfy the same conditions for the same range.

Submicron recess 11 has a linear density, which indicates the number of submicron recesses 11 which exist per unit length (1 nm) within the range of the reference length of 80 nm. Accordingly, if there are seven rolling circles 13A in the range of reference length (L_{w}) of 80 nm, as shown in Fig. 10, submicron recess 11 will have a linear density of 7/80 = 0.0875 nm⁻¹.

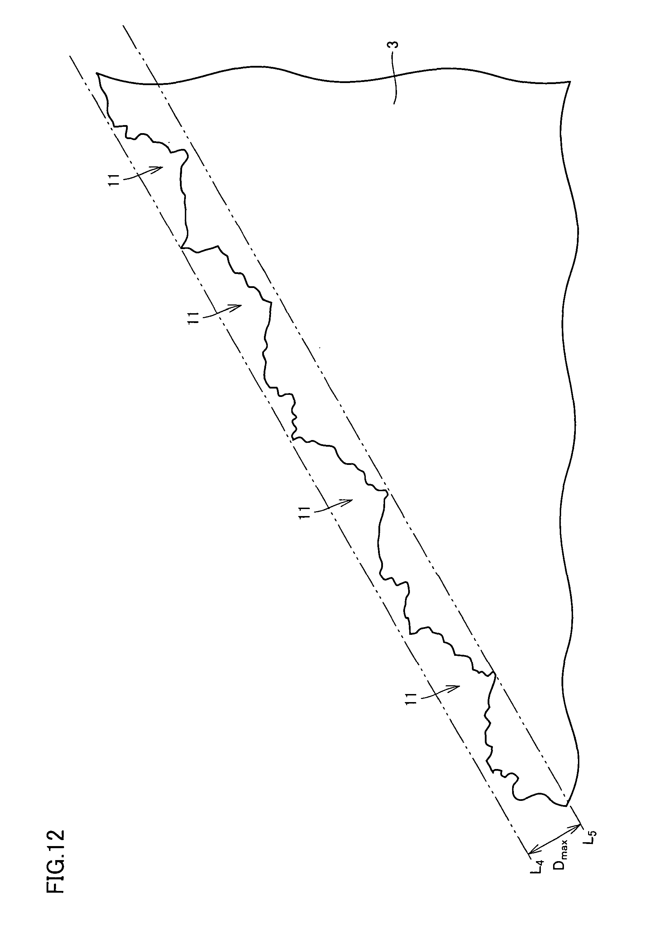

Fig. 12 illustrates a maximum depth of submicron recesses. As shown in Fig. 12, submicron recesses 11 have a maximum depth (Dₘₐₓ), which is a distance between two straight lines (L₄, L₅) which are parallel to the measured average line and in contact with the measurement cross section line within the range of the reference length of 80 nm. The Fig. 10 submicron recesses 11 had a maximum depth of 4 nm.

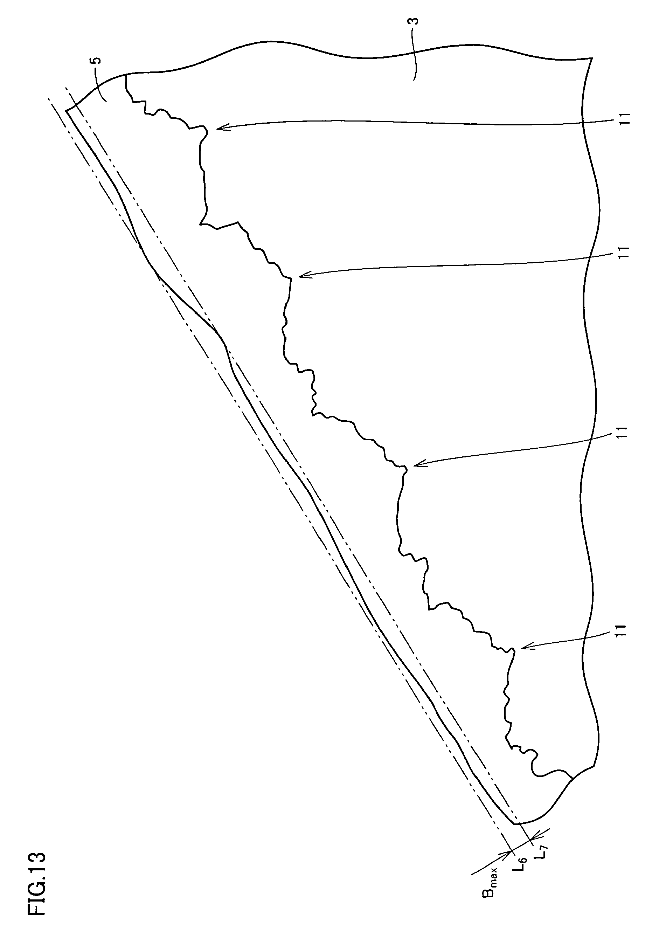

Fig. 13 illustrates a maximum depth of an interface of a p layer and an i layer. As shown in Fig. 13, p layer 5 and i layer 6 have a slightly wavy interface. The interface of p layer 5 and i layer 6 has a maximum depth (Bₘₐₓ), which indicates a distance between two straight lines (L₆, L₇) which are parallel to the measured average line and in contact with interface 12 of p layer 5 and i layer 6 in a cross section for measurement. A method similar to that for maximum depth (Dₘₐₓ) of submicron recess 11 was used in a region corresponding to a region in which maximum depth (Dₘₐₓ) of submicron recess 11 was measured to measure maximum depth (Bₘₐₓ) of the interface of p layer 5 and i layer 6.

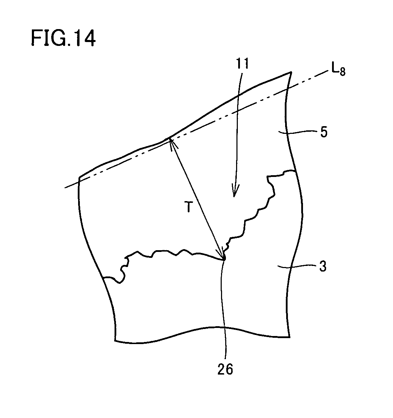

Fig. 14 illustrates the p layer's thickness. As shown in Fig. 14, p layer 5 has a thickness, which indicates a thickness in a direction which is orthogonal to a straight line (L₈) parallel to the measured average line. The layer on a bottom 26 of submicron recess 11 has a thickness of a length T shown in Fig. 14.

Hereinafter will be described a method for producing photoelectric conversion device 1 of the present embodiment and its function.

Atmospheric pressure CVD is employed to deposit SnO₂:F on an upper surface of glass substrate 2 to form transparent, electrically conductive film 3 having bump 10 having a maximum height equal to or larger than 50 nm and equal to or smaller than 1200 nm. The substrate with transparent, electrically conductive film 3 having bump 10 will hereinafter be referred to as a transparent conductive oxide (TCO) substrate. While in the present embodiment transparent, electrically conductive film 3 is formed of SnO₂:F, it may be formed of In₂O₃, ZnO:Al, ZnO:Ga, ITO or other similar transparent, electrically conductive material.

Furthermore, while in the present embodiment atmospheric pressure CVD is employed to form transparent, electrically conductive film 3 having a textured structure, vacuum deposition, EB vacuum deposition, sputtering, vacuum CVD, a sol-gel method, electrocrystallization or the like may be employed to do so.

Then, the TCO substrate is subjected to a hydrogen containing plasma treatment in a parallel plate, capacitively-coupled RF plasma reaction chamber. This hydrogen containing plasma treatment is performed such that a main reducing reaction species that reaches a surface of the TCO may be a hydrogen radical. As a result of etching with the hydrogen radical used as a reacting species, submicron recess 11 is formed in a surface of bump 10 of transparent, electrically conductive film 3. It is believed that the etching is not performed uniformly throughout the surface layer but submicron recess 11 is instead formed because the etching is done faster at a defect that exists in the surface of the TCO substrate than at other portions.

In the present embodiment, gaseous hydrogen (H₂) was employed as the only gas species that was introduced into the plasma reaction chamber, which allowed simple production facilities to be employed. The gaseous hydrogen was introduced into the plasma reaction chamber at a flow rate of 70 SLM. Note, however, that gaseous nitrogen, argon, xenon or the like and gaseous hydrogen mixed together may be used as a gas species introduced into the plasma reaction chamber. In the present embodiment, a "hydrogen containing plasma" is not limited to that employing only gaseous hydrogen, and it also means any plasma providing a hydrogen radical as a reacting species, that employs such a gaseous mixture.

In the present embodiment, the plasma reaction chamber had an internal pressure set at 600 Pa. When the plasma reaction chamber has an increased internal pressure, the hydrogen radical has an increased density, and accordingly, the TCO substrate has a surface with submicron recess 11 having an increased maximum depth. When the plasma reaction chamber has a decreased internal pressure, the TCO substrate's surface receives an increased ion damage, and accordingly, the TCO substrate has a surface with submicron recess 11 having an increased linear density. In order to increase submicron recess 11 in depth and linear density, it is preferable that the plasma reaction chamber have an internal pressure equal to or larger than 100 Pa and equal to or smaller than 1500 Pa.

In the present embodiment, the plasma reaction chamber was powered with a power density of 40 mW/cm². When the hydrogen plasma treatment is performed with larger power density, hydrogen radical is generated in the plasma reaction chamber more densely. Accordingly, a hydrogen plasma treatment performed with a larger power density allows the TCO substrate to have a surface with submicron recess 11 having a larger maximum depth and a larger linear density.

Note, however, that excessively large power density results in the TCO substrate having SnO₂ that constitutes transparent, electrically conductive film 3 reduced in a significantly large amount, and accordingly, transparent, electrically conductive film 3 has Sn precipitated in a vicinity of a surface thereof and is thus impaired in transmittance. The TCO substrate reduced in transmittance results in photoelectric conversion device 1 generating power inefficiently, and accordingly, it is necessary to avoid excessively increasing power density. Accordingly, preferably, the plasma reaction chamber is powered with a power density equal to or larger than 10 mW/cm² and equal to or smaller than 200 mW/cm².

The treatment in the plasma reaction chamber was performed for 15 seconds. When the treatment is performed for an increased period of time, the TCO substrate will have a surface with submicron recess 11 having a larger maximum depth and a larger linear density.

Note, however, that excessively long treatment time results in the TCO substrate having SnO₂ that constitutes transparent, electrically conductive film 3 reduced in a significantly large amount, and accordingly, transparent, electrically conductive film 3 has Sn precipitated in a vicinity of a surface thereof and is thus impaired in transmittance. The TCO substrate reduced in transmittance results in photoelectric conversion device 1 generating power inefficiently, and accordingly, it is necessary to avoid excessively increasing the treatment time. Accordingly, preferably, the treatment is performed in the plasma reaction chamber for a period of time of 5-200 seconds.

If the hydrogen containing plasma treatment is performed with a pulsed plasma, it may be turned on and off at a varying duty ratio to provide a controlled effective treatment time. Desirably, the plasma is pulsed on/off at a frequency sufficiently lower than a plasma excitation frequency (of 5 MHz to 80 MHz) (i.e., 100 Hz to 10 kHz). The duty ratio can be set at 0.05-0.5. Small duty ratio and large power input allow the treatment to proceed at a controlled rate and can prevent the treatment from causing a large ion damage to the substrate.

It is believed that the hydrogen containing plasma treatment is proportional in intensity to a total energy that the substrate receives from the plasma in the process of the treatment. The total energy that the substrate receives from the plasma is proportional to the density of the power input to generate the plasma, the treatment time, and the pulsing duty ratio. Preferably, the total energy per unit area (= power density (mW/cm²) x treatment time (sec) x duty ratio) is 20 mJ/cm² to 300 mJ/cm².

In the present embodiment, the hydrogen containing plasma treatment is performed with the substrate set to have a temperature of 190 degrees centigrade. The treatment performed with the substrate set at an increased temperature results in the TCO substrate with bump 10 having a surface with a smaller difference in reduction kinetics between a defective portion and the other portions. As such, the TCO substrate has bump 10 having a surface entirely etched and thus has a surface with submicron recess 11 formed with a reduced maximum depth and a reduced linear density. Accordingly, the hydrogen containing plasma treatment is preferably performed with the substrate set at a temperature equal to or higher than a room temperature (20 degrees centigrade) and equal to or lower than 200 degrees centigrade.

Preferably, before the above hydrogen containing plasma treatment is performed, a treatment is performed to introduce a defect into a surface of the TCO substrate. This defect is a defect which serves as submicron recess 11 by the hydrogen containing plasma treatment. For example, a power density which is significantly more intense than a condition for the hydrogen containing plasma treatment step is applied and in that condition the TCO substrate undergoes a plasma treatment for an extremely short period of time. This treatment introduces into a surface of the TCO substrate a defect which is believed to be caused by ion damage. Larger power density allows the defect to have larger linear density, which allows the subsequent hydrogen containing plasma treatment to cause submicron recess 11 having an increased linear density.

If the above defect introduction step employs a plasma, then, larger plasma potential allows ion damage to reach from the surface of the TCO substrate to a deep site thereof. This causes a deep defect and it is thus believed that the subsequent hydrogen containing plasma treatment causes submicron recess 11 having an increased maximum depth. Plasma potential can be increased for example by using a plasma pulsing for a short period of time with each pulse having an on period equal to or shorter than 1 millisecond or by increasing a power density applied to generate a plasma, or the like. Furthermore, the plasma can be generated by using gaseous argon, xenon or a similar gas species having a relatively large atomic weight.

If the defect introduction step is a hydrogen containing plasma treatment performed with a plasma generated with an increased power density applied, then, after the defect introduction step completes, the plasma may not be switched off but the power density can instead be reduced to shift to the subsequent hydrogen containing plasma treatment step. This allows the product to be produced in a reduced period of time in a simplified production apparatus.

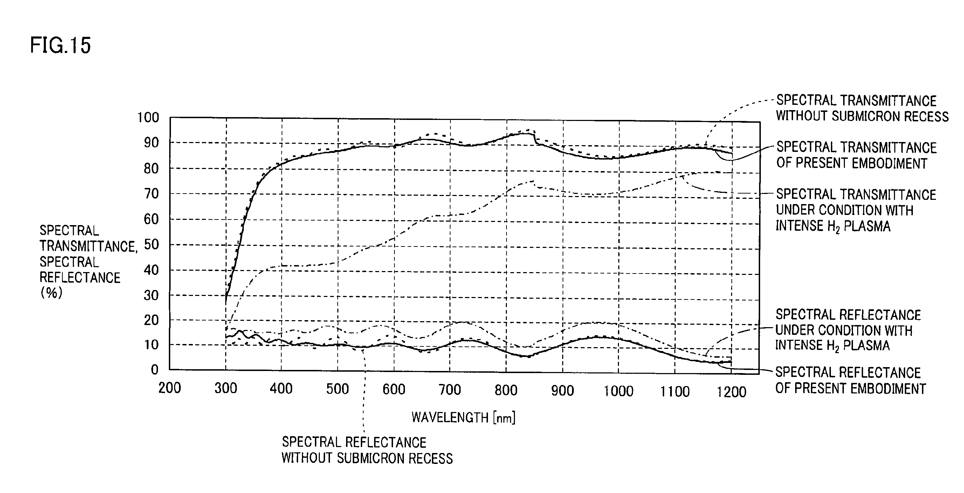

Fig. 15 plots spectral transmittance and spectral reflectance for each of a substrate for the photoelectric conversion device of the present embodiment, a substrate for a photoelectric conversion device which does not have submicron recesses, and a substrate for a photoelectric conversion device having undergone an intense hydrogen plasma treatment. In Fig. 15, the axis of ordinate represents spectral transmittance and spectral reflectance, and the axis of abscissa represents incident light in wavelength. A solid line represents data of substrate 4 for the photoelectric conversion device of the present embodiment, a dotted line represents data of the substrate for the photoelectric conversion device which does not have submicron recess 11, and an alternate long and short dash line represents data of the substrate for the photoelectric conversion device having undergone the intense hydrogen plasma treatment.

The substrate for the photoelectric conversion device which does not have the submicron recess has not undergone the hydrogen containing plasma treatment step and hence the TCO substrate does not have a surface with submicron recess 11. The substrate for the photoelectric conversion device that does not have the submicron recess has the remainder similar in configuration to substrate 4 for the photoelectric conversion device of the present embodiment.

The TCO substrate of the photoelectric conversion device which undergoes the intense hydrogen plasma treatment has undergone a hydrogen plasma treatment step using an intense hydrogen plasma for a period of time of 300 seconds. The substrate for the photoelectric conversion device having undergone the intense hydrogen plasma treatment has the remainder similar in configuration to substrate 4 for the photoelectric conversion device of the present embodiment.

As represented in Fig. 15, the substrate for the photoelectric conversion device having undergone the intense hydrogen plasma treatment is significantly impaired in spectral transmittance. This indicates that, as has been set forth above, transparent, electrically conductive film 3 is reduced in a large amount and hence impaired in transmittance.

For incident light having a wavelength in a range from about 400 nm to about 700 nm, substrate 4 for the photoelectric conversion device of the present embodiment exhibits spectral transmittance and spectral reflectance increased/decreased with a smaller amplitude than the substrate for the photoelectric conversion device which does not have submicron recess 11. It is believed that this is because substrate 4 for the photoelectric conversion device of the present embodiment less easily causes interference of light in transparent, electrically conductive film 3 than the substrate for the photoelectric conversion device which does not have submicron recess 11. A ground therefor is believed to be scattering of light attributed to submicron recess 11.

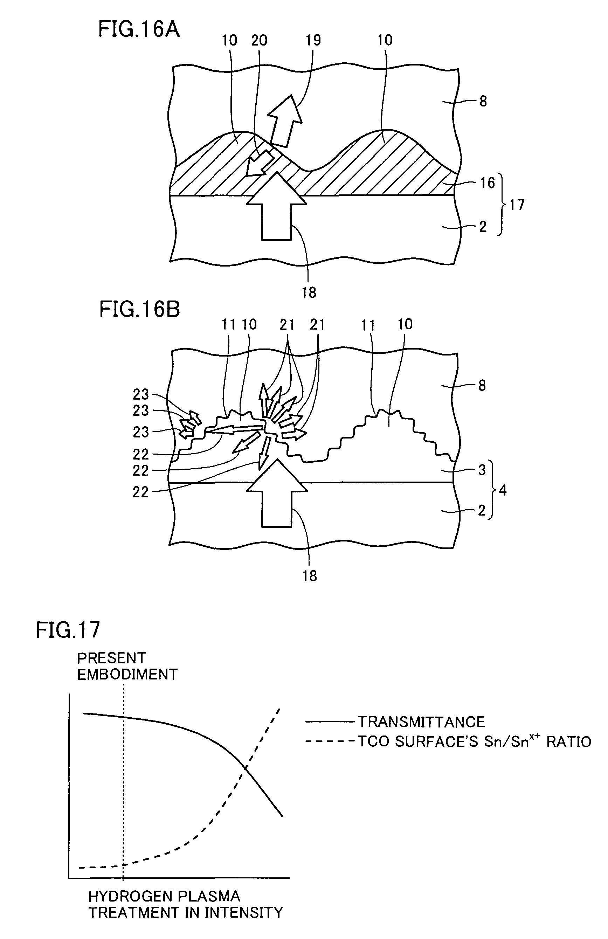

Fig. 16A is a cross section schematically showing how light propagates in the photoelectric conversion device which is not provided with submicron recesses. Fig. 16B is a cross section schematically showing how light propagates in the photoelectric conversion device of the present embodiment.

As represented in Fig. 16A, light 18 incident on transparent, electrically conductive film 16 which does not have submicron recess has a portion transmitted through the interface of transparent, electrically conductive film 16 and photoelectric conversion layer 8 and thus providing transmitted light 19, and a portion reflected by the interface and thus providing reflected light 20.

As represented in Fig. 16B, light 18 incident on transparent, electrically conductive film 3 of the present embodiment has a portion transmitted through the interface of transparent, electrically conductive film 3 and photoelectric conversion layer 8 and thus providing transmitted light 21, and a portion reflected by the interface and thus providing reflected light 22. It is believed that transmitted light 21 and reflected light 22 are dispersed by submicron recess 11 in a wide range in direction.

It is thus believed that substrate 4 for the photoelectric conversion device of the present embodiment less easily causes interference of light having a wavelength in a range from about 400 nm to about 700 nm than the substrate for the photoelectric conversion device which does not have submicron recess 11.

Furthermore, as represented in Fig. 16B, it is believed that photoelectric conversion device 1 of the present embodiment has a portion of reflected light 22 that is reflected at the interface of transparent, electrically conductive film 3 and photoelectric conversion layer 8, propagating to submicron recess 11 located at a slanting surface facing that of bump 10 that has reflected reflected light 22. It is believed that the partial portion of reflected light 22 is further dispersed by submicron recess 11 and partially propagates through photoelectric conversion layer 8 as transmitted light 23. It is believed that this can provide an increased quantity of light incident on photoelectric conversion layer 8 and hence increase light contributing to power generation.

Although why extremely small submicron recess 11 having a width equal to or larger than 2 nm and equal to or smaller than 25 nm scatters light is unknown in detail, the width of submicron recess 11 is 1/10 or smaller of the wavelength of the solar light incident on substrate 4 for the photoelectric conversion device, 1/10 or smaller of a wavelength of about 350 nm to about 1100 nm, which provides energy large in intensity, in particular, and it is thus inferred that each one of submicron recesses 11 allows Rayleigh scattering of the incident light. Rayleigh scattering applies only when the scatterer is significantly smaller in dimension than the wavelength of the light. For light having shorter wavelength, a larger degree of scattering is provided, and a larger scatterer provides a larger degree of scattering.

When the irregular surface of transparent, electrically conductive film 3 is discussed from the above, submicron recess 11 having a width equal to or larger than 2 nm and equal to or smaller than 25 nm functions to scatter light incident thereon and provides a larger extent of scattering for incident light having shorter wavelength. It is thus believed that a photoelectric conversion device having a plurality of photoelectric conversion layers has an optical path having an increased length in the first photoelectric conversion layer located immediately adjacent to transparent, electrically conductive film 3. Note that the first photoelectric conversion layer has an i layer having a main component for example of hydrogenated amorphous silicon or hydrogenated amorphous silicon carbon. If light of short wavelength experiences Rayleigh scattering, it is believed that the reflected light at submicron recess 11 is also scattered significantly. As a result, a probability that the light reflected by a single bump 10 at one of its two opposite slanting surfaces and scattered is again incident on the other slanting surface, increases. Thus if the first photoelectric conversion layer has an i layer with a relatively small thickness it can nonetheless sufficiently absorb light of short wavelength. This can reduce an effect that photodegrades the i layer when the i layer contains an amorphous silicon based material as a main component.

Of short wavelengths of light, a range of about 350 nm to about 550 nm, for which solar light has relatively large energy intensity, should be absorbed by photoelectric conversion layer 8 at increased rate, and accordingly, submicron recess 11 preferably has local peaks spaced by 25 nm or smaller, particularly preferably 20 nm or smaller. Furthermore, it is believed that more submicron recesses 11 provide a larger light scattering effect and accordingly, submicron recess 11 preferably has a linear density equal to or larger than 0.05 nm⁻¹, and particularly preferably equal to or larger than 0.07 nm⁻¹. It should be noted, however, that excessively large linear density results in each one of submicron recesses 11 having local peaks spaced excessively narrowly resulting in a reduced light scattering effect, and accordingly, a linear density of 0.3 nm⁻¹ or smaller is preferable, and a linear density of 0.1 nm⁻¹ or smaller is particularly preferable. Preferably, the submicron recess is formed substantially throughout any raised surface of the transparent, electrically conductive film.

Incident light of relatively long wavelength results in a small degree of Rayleigh scattering, and it is believed that scattering of light based on a geometrical optical or Mie-scattering mechanism by bump 10 having a maximum height mainly equal to or larger than 50 nm and equal to or smaller than 1200 nm is dominant. It is believed that the fact that in Fig. 15, for incident light of a wavelength equal to or larger than about 800 nm, substrate 4 for the photoelectric conversion device of the present embodiment and the substrate for the photoelectric conversion device without the submicron recess substantially match in spectral reflectance, supportively evidences that light of relatively long wavelength results in a small degree of Rayleigh scattering. It is thus believed that an optical path within the first photoelectric conversion layer located in a vicinity of transparent, electrically conductive film 3 has a relatively small length.

Accordingly, the quantity of light of long wavelength absorbed by the first photoelectric conversion layer is not much increased by Rayleigh scattering, and it is thus believed that the quantity of light of long wavelength incident on the second photoelectric conversion layer stacked at a position which covers the first photoelectric conversion layer increases. Note that the second photoelectric conversion layer has an i layer having a main component for example of hydrogenated amorphous silicon germanium, hydrogenated microcrystalline silicon, or hydrogenated microcrystalline silicon germanium. As a result, the second photoelectric conversion layer can have the i layer to absorb an increased quantity of light. If the first photoelectric conversion layer has an i layer reduced in thickness, as described above, the second photoelectric conversion layer can have the i layer to absorb a further increased quantity of light.

From the above discussion it can be understood that the substrate for the photoelectric conversion device of the present invention is suitably applied to a so called super straight type photoelectric conversion device of stacked layers. The photoelectric conversion device of stacked layers has a substrate and a plurality of photoelectric conversion layers stacked to cover a major surface of the substrate. Increasing the band gap of the i layer of a photoelectric conversion layer closer to a side on which light is incident to mainly absorb light of short wavelength, and decreasing the band gap of the i layer of a photoelectric conversion layer remoter from the side on which light is incident to mainly absorb light of long wavelength, allow incident light to be utilized in an increased range in wavelength to achieve more efficient photoelectric conversion.

Furthermore, the super straight type means a type having a glass or similar transparent substrate having one major surface at least partially covered with a transparent, electrically conductive film, and another major surface on which light is incident.

The super straight type photoelectric conversion device of stacked layers with substrate 4 for the photoelectric conversion device that has submicron recess 11 significantly scatters light of short wavelength so that the first photoelectric conversion layer formed at a position close to the incidence side absorbs an increased quantity of light of short wavelength. In contrast, providing a relatively small scattering of light of long wavelength so that an average optical path for light of long wavelength in the first photoelectric conversion layer is shorter in length than that for light of short wavelength therein, can reduce the quantity of light of long wavelength absorbed by the first photoelectric conversion layer and accordingly increase the quantity of light of long wavelength incident on the second photoelectric conversion layer formed at a position remote from the incidence side, and the photoelectric conversion device can thus achieve more efficient photoelectric conversion.

In contrast, an irregular surface with submicron recess 11 excessively small in dimension is similar to an irregular surface substantially without submicron recess 11 and thus provides a reduced Rayleigh scattering effect. In this point of view, submicron recess 11 preferably has local peaks spaced by 5 nm or larger.

Thus submicron recess 11 can scatter light to be incident on photoelectric conversion layer 8 and thus allows light to propagate through photoelectric conversion layer 8 along an optical path having an increased length. As a result, photoelectric conversion layer 8 achieves more efficient photoelectric conversion and photoelectric conversion device 1 provides increased short circuit current density (Jsc).

When photoelectric conversion device 1 of the present embodiment is compared with the photoelectric conversion device without submicron recess 11 the former has photoelectric conversion layer 8 and the TCO substrate adhered together with larger strength than the latter. If photoelectric conversion layer 8 is deposited on a surface of TCO substrate 17 which does not have submicron recess 11, as shown in Fig. 16A, the surface of TCO substrate 17 and photoelectric conversion layer 8 are adhered together with relatively small strength. If photoelectric conversion layer 8 is deposited on a surface of a TCO substrate having submicron recess 11, as shown in Fig. 16B, the surface of TCO substrate and photoelectric conversion layer 8 are adhered together with relatively large strength.

It is believed that a first cause of the difference in the adhesive strength between the surface of the TCO substrate and photoelectric conversion layer 8 is a difference in an area in which the surface of the TCO substrate and photoelectric conversion layer 8 contact each other. Submicron recess 11 allows the surface of the TCO substrate and photoelectric conversion layer 8 to contact each other over a drastically increased area. It is believed that this allows the surface of the TCO substrate and photoelectric conversion layer 8 to be adhered together with increased strength.

It is believed that a second cause of the difference in the adhesive strength between the surface of the TCO substrate and photoelectric conversion layer 8 is a difference of submicron recess 11 in dimension. The present embodiment provides submicron recess 11 having a small width with local peaks having a spacing equal to or larger than 2 nm and equal to or smaller than 25 nm. Accordingly, the surface of the TCO substrate and photoelectric conversion layer 8 have such an interface that photoelectric conversion layer 8 enters into submicron recess 11 having small width.

It is believed that at the thus intricately complicated interface an anchor effect works between the surface of the TCO substrate and photoelectric conversion layer 8 and thus provides a significantly increased adhesive strength between the surface of the TCO substrate and photoelectric conversion layer 8. Accordingly, preferably, submicron recess 11 has a maximum depth equal to or larger than 2 nm. Furthermore submicron recess 11 formed on a surface of bump 10 at at least a prescribed ratio can stabilize the anchor effect. Accordingly, preferably, submicron recess 11 has a linear density equal to or larger than 0.05 nm⁻¹.

It is believed that a third cause of the difference in the adhesive strength between the surface of the TCO substrate and photoelectric conversion layer 8 is a difference in activity at the surface of the TCO substrate. In the present embodiment, submicron recess 11 is formed by a hydrogen containing plasma treatment. The surface of TCO substrate 17 without submicron recess 11 as shown in Fig. 16A is in a chemically relatively stable state, and it is an inactive surface with dangling bonds having a relatively small number density. Accordingly, it is believed that TCO substrate 17 and photoelectric conversion layer 8 have a relatively small, mutually chemically bonded portion. In particular, when the substrate has a large area equal to or larger than 1 m² and does not have its surface subjected to the hydrogen containing plasma treatment, the photoelectric conversion layer occasionally peels off.

It is believed that the hydrogen containing plasma treatment allows hydrogen radical to dissociate at the surface of the TCO substrate the oxygen contained in the TCO substrate, and a dangling bond to be formed in the surface of the TCO substrate. As it is inferred that submicron recess 11 is formed as hydrogen radical preferentially etches defects on a surface of the transparent, electrically conductive film, it is inferred that this dangling bond may exist relatively more in a vicinity of the trough of submicron recess 11 than in a relatively smooth place without submicron recess 11.

This dangling bond is labile, and accordingly, when photoelectric conversion layer 8 is formed of silicon, a SiH₃ radical or the like firmly bonds to the dangling bond that is formed in the surface of the TCO substrate. Accordingly, the TCO substrate and photoelectric conversion layer 8 have a relatively large, mutually chemically bonded portion. As a result, it is believed that the TCO substrate and photoelectric conversion layer 8 are adhered together with increased strength.

Fig. 17 is a graph which shows how a characteristic value of a TCO substrate varies with the intensity of the hydrogen containing plasma treatment. In Fig. 17, the axis of ordinate represents the transmittance of the TCO substrate, and the ratio of Sn/Sn^{x+} in the surface of the TCO substrate, and the axis of abscissa represents the hydrogen containing plasma treatment in intensity. Furthermore, in Fig. 17, a dotted line represents a condition for the hydrogen containing plasma treatment in the present embodiment.

As shown in Fig. 17, in the present embodiment, the hydrogen containing plasma treatment is performed under such a condition that the treatment has an extent in intensity allowing metal Sn to start to precipitate slightly in a vicinity of a surface of the TCO substrate. Metal Sn precipitates when SnO₂ that configures transparent, electrically conductive film 3 is reduced by hydrogen radical.

As described above, as a result of the hydrogen containing plasma treatment step reducing and etching a surface of the TCO substrate by hydrogen radical, the TCO substrate's surface has a surface layer formed with a reduced metal atom having a slightly higher density than the substrate's bulk portion. This surface layer has submicron recess 11 formed thereon.

The present embodiment in a third exemplary variation may provide a hydrogen containing plasma treatment step followed by a hydrogen plasma treatment containing a small amount of carbon (hereinafter referred to as a "mixed plasma"). It is believed that in the mixed plasma, there exists for example a CH₃ radical or a similar radical having a carbon atom. Hereinafter, a mixed-plasma treatment will be described by referring to a CH₃ radical as an example.

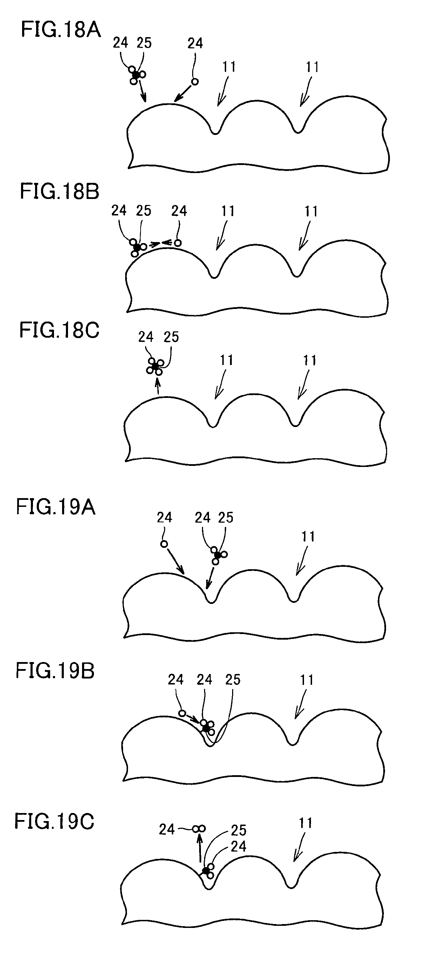

Figs. 18A-18C schematically illustrate a chemical reaction in the mixed-plasma treatment at a portion of the TCO substrate other than submicron recesses. Figs. 19A-19C schematically illustrate a chemical reaction in the mixed-plasma treatment at a submicron recess of the TCO substrate. In Fig. 18A to Fig. 18C and Fig. 19A to Fig. 19C, a hydrogen atom 24 is represented by a white dot and a carbon atom 25 is represented by a black dot.

In the mixed-plasma treatment, as shown in Fig. 18A, at a portion of the TCO substrate other than submicron recess 11, CH₃ radical and hydrogen radical are physisorbed to a surface of the TCO substrate. Thereafter, as shown in Fig. 18B, the CH₃ radical and the hydrogen radical thermally diffuse at the surface of the TCO substrate. Then, as shown in Fig. 18C, the CH₃ radical and the hydrogen radical are dessociated from the surface of the TCO substrate by recombination.

In contrast, at submicron recess 11 of the TCO substrate, as shown in Fig. 19A, the CH₃ radical and the hydrogen radical are physisorbed to a surface of the TCO substrate and thereafter thermally diffuse. Then, as shown in Fig. 19B, at submicron recess 11, a dangling bond exists providing high lability, and the CH₃ radical thus chemically bonds to the dangling bond of the submicron recess. Then, as shown in Fig. 19C, a CH₃ group that has bonded at the submicron recess and the hydrogen radical collide, and as the TCO substrate and carbon atom 25 have a large bonding strength, a hydrogen molecule is dessociated, and carbon atom 25 having a dangling bond bonds in a vicinity of submicron recess 11.

Note that the hydrogen containing plasma treatment step and the mixed-plasma treatment step can be successively performed with the plasma continuously turn on. Specifically, for example, a solid carbon source which reacts with hydrogen plasma to generate carbon based radical is introduced into a plasma reaction chamber. In that condition the hydrogen plasma is turn on so that when the hydrogen plasma treatment starts, a treatment is performed by a substantially pure hydrogen plasma. As time elapses, the amount of carbon based radical contained in the plasma increases and the mixed-plasma treatment will thus be performed. By the process described so far, the substrate for the photoelectric conversion device is produced.

Note that the defect introduction step and the mixed-plasma treatment step are not a requirement.

After the mixed-plasma treatment step, a plasma-CVD apparatus is employed to deposit p layer 5. A SiH₃ radical or the like that is a precursor, after it has thermally diffused on a surface of the TCO substrate, has a portion chemically bonded at a chemically active site. Submicron recess 11 is an active site with a large number of dangling bonds, and when the mixed-plasma treatment is performed, a large number of carbon atoms of CH₂ group or the like having a dangling bond exist in a vicinity of submicron recess 11, and accordingly, the SiH₃ radical easily chemically bonds at submicron recess 11 to the TCO substrate or to a carbon atom of a CH₂ group bonded to the TCO substrate. Thus, at submicron recess 11, p layer 5 and the TCO substrate are firmly bonded together.

Preferably, p layer 5 is equal to or larger than 5 nm and equal to or smaller than 15 nm in thickness. P layer 5 of 5 nm or larger in thickness allows photoelectric conversion device 1 to have a sufficiently large internal electric field. P layer 5 of 15 nm or smaller in thickness allows an amorphous silicon based solar cell or a similar photoelectric conversion device in which absorption of light in p layer 5 does not contribute to power generation to reduce a loss attributed to absorption of light in p layer 5.

As p layer 5 is preferably equal to or larger than 5 nm and equal to or smaller than 15 nm in thickness, submicron recess 11 preferably has a maximum depth of 10 nm or smaller so that p layer 5 can appropriately cover submicron recess 11 of transparent, electrically conductive film 3.

Thereafter i layer 6 and n layer 7 are successively deposited by a plasma-CVD apparatus to deposit photoelectric conversion layer 8. Finally, zinc oxide and then silver are deposited by a sputtering apparatus to cover n layer 7 to provide back surface electrode layer 9. The above process produces photoelectric conversion device 1 of the present embodiment. Photoelectric conversion layer 8 and back surface electrode layer 9 can be provided by a method employed for a typical thin film solar cell or the like.

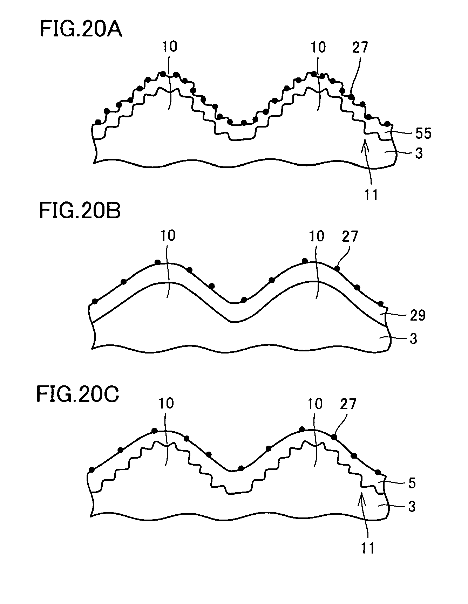

Hereinafter, a preferable p layer 5 for photoelectric conversion device 1 in the present embodiment will be described. Fig. 20A is a schematic diagram showing an interface of a p layer and an i layer in a hypothetical photoelectric conversion device. Fig. 20B is a schematic diagram showing an interface of a p layer and an i layer in a conventional photoelectric conversion device. Fig. 20C is a schematic diagram showing an interface of a p layer and an i layer in the photoelectric conversion device of the present embodiment. In Fig. 20A to Fig. 20C, a defect which exists at the interface of the p layer and the i layer is indicated by a black dot. This defect has an interface state serving as a recombination center of a carrier.

As shown in Fig. 20A, in the hypothetical photoelectric conversion device, p layer 55 and the i layer have an interface having traced thereon the geometry of submicron recess 11 of a surface of the TCO substrate. Thus p layer 55 and the i layer have an interface having a relatively large area and also having a relatively large number of defects 27.

As shown in Fig. 20B, in the conventional photoelectric conversion device, submicron recess 11 is not provided, and p layer 29 and the i layer have an interface having traced thereon the geometry of a surface of the TCO substrate. Thus p layer 29 and the i layer have an interface having a relatively small area and hence a relatively small number of defects 27.

As shown in Fig. 20C, in the photoelectric conversion device of the present embodiment, p layer 5 and i layer 6 do not have an interface having traced thereon the geometry of submicron recess 11 of a surface of the TCO substrate. Thus p layer 5 and i layer 6 have an interface having a relatively small area and a relatively small number of defects 27.

While photoelectric conversion device 1 of the present embodiment is provided with submicron recess 11, the device has p layer 5 and i layer 6 with their interface having a relatively small number of defects 27 and can thus reduce carrier recombination frequency to an extent equivalent to that of the conventional photoelectric conversion device.

Furthermore, photoelectric conversion device 1 of the present embodiment, as compared with the hypothetical photoelectric conversion device, can reduce diffusion into i layer 6 of boron contained in p layer 5 and carbon contained in p layer 5 if carbon is used as a component of p layer 5. It is believed that if the device has i layer 6 configured of a hydrogenated silicon based material, the device can be as effective as the conventional photoelectric conversion device in preventing impurity from diffusing toward i layer 6 and thus developing photodeterioration.

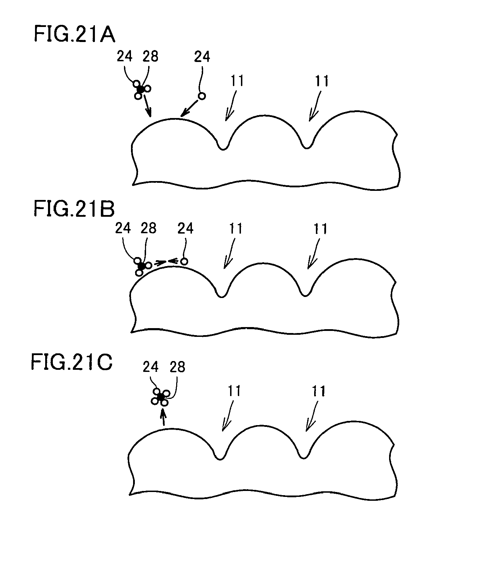

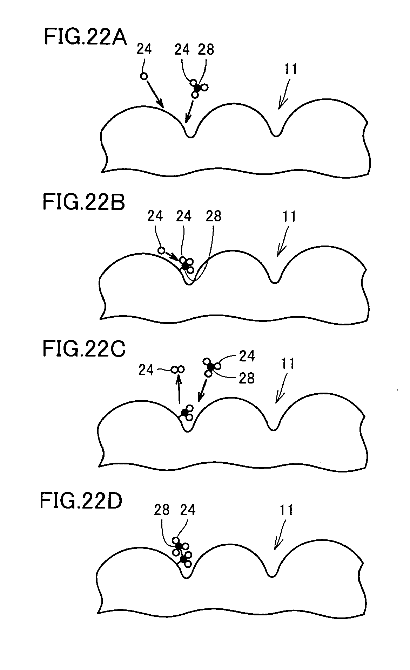

A reason why photoelectric conversion device 1 of the present embodiment can have the interface of p layer 5 and i layer 6 without having the geometry of the submicron recess of the surface of the TCO substrate traced thereon, will be described hereinafter. Figs. 21A-21C schematically illustrate a chemical reaction at a portion of the TCO substrate other than the submicron recesses. Figs. 22A-22D schematically illustrate a chemical reaction at a submicron recess of the TCO substrate. In Fig. 21A to Fig. 21C and Fig. 22A to Fig. 22D, hydrogen atom 24 is represented by a white dot and a silicon atom 28 is represented by a black dot.

When layer 5 starts to deposit on the TCO substrate, then, at a location on the TCO substrate that is remote from submicron recess 11, as shown in Fig. 21A, SiH₃ radical and hydrogen radical are physisorbed to a surface of the TCO substrate. Thereafter, as shown in Fig. 21B, the SiH₃ radical and the hydrogen radical thermally diffuse at the surface of the TCO substrate. Then, as shown in Fig. 21C, the location remote from submicron recess 11 has a low density of active sites such as dangling bonds, and accordingly, there is a high probability that the SiH₃ radical and the hydrogen radical are dessociated from the surface of the TCO substrate by recombination.

In contrast, when p layer 5 starts to deposit on the TCO substrate, then, in a vicinity of submicron recess 11 of the TCO substrate, as shown in Fig. 22A, SiH₃ radical and hydrogen radical are physisorbed to a surface of the TCO substrate and thereafter thermally diffuse.

Then, as shown in Fig. 22B, at submicron recess 11, a dangling bond exists providing high lability, and the SiH₃ radical is thus chemically bonded to the dangling bond of submicron recess 11. Then, as shown in Fig. 22C, a SiH₃ group that has bonded at the submicron recess and the hydrogen radical collide, and as the TCO substrate and the silicon atom have a large bonding strength, a hydrogen molecule is dessociated, and a SiH₂ group having a dangling bond thus bonds in a vicinity of submicron recess 11. As shown in Fig. 22D, a SiH₃ radical chemically bonds to the SiH₂ group having a dangling bond, and binding of a precursor to the TCO substrate and deposition of the p layer thus proceed in a vicinity of submicron recess 11.

It is thus believed that p layer 5 deposits faster in the vicinity of submicron recess 11 than at the location remote from submicron recess 11. Accordingly, p layer 5 is larger in thickness at bottom 26 of submicron recess 11 than at a portion other than bottom 26. Furthermore, maximum depth (Bₘₐₓ) of the interface of p layer 5 and i layer 6 is smaller than maximum depth (Dₘₐₓ) of submicron recess 11. As a result, the interface of p layer 5 and i layer 6 is a gently sloping line as seen in the measurement cross section.

Thus, submicron recess 11 can be formed without p layer 5 and i layer 6 having an interface having increased defects and hence providing increased carrier recombination resulting in inefficient photoelectric conversion.

In the present embodiment a transparent, electrically conductive film can be exposed to a hydrogen containing plasma to have submicron recess 11 having local peaks having a spacing equal to or larger than 2 nm and equal to or smaller than 25 nm to allow incident light to travel an optical path having an increased length to achieve more efficient photoelectric conversion. Furthermore, substrate 4 for a photoelectric conversion device and photoelectric conversion layer 8 can be bonded with increased strength to improve photoelectric conversion device 1 in stability. To obtain these effects, submicron recess 11 preferably has a linear density equal to or larger than 0.05 nm⁻¹. Furthermore, preferably, submicron recess 11 has a maximum depth equal to or larger than 2 nm and equal to or smaller than 10 nm.

Although the above embodiment has been described specifically for a so called super straight type thin film silicon based solar cell, it may be a thin film solar cell employing CdTe as a light absorption layer. Furthermore, for a so called sub-straight type thin film solar cell, a transparent, electrically conductive film at a light incidence side and a first conduction type semiconductor layer (a conduction type silicon based thin film or a zinc compound thin film) may have an interface having bumps and recesses. This irregular geometry may have bumps having a maximum height equal to or larger than 50 nm and equal to or smaller than 1200 nm, and submicron recesses formed on a surface of the bump and having local peaks having a spacing equal to or larger than 2 nm and equal to or smaller than 25 nm.

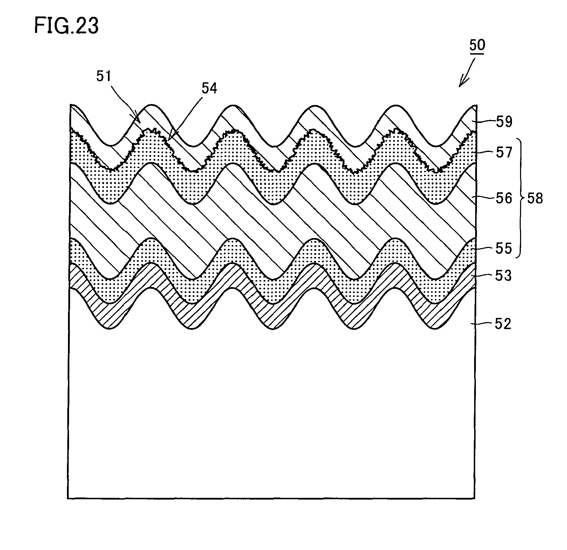

Fig. 23 is a cross section showing a structure of a sub-straight type thin film solar cell with the present invention applied thereto. A sub-straight type thin film solar cell 50 with the present invention applied thereto as shown in Fig. 23 includes a substrate 52, a back surface electrode layer 53 covering at least a portion of a major surface of substrate 52, a light absorption layer 56 covering at least a portion of a major surface of back surface electrode layer 53, a first conduction type layer 57 of a first conduction type covering at least a portion of a major surface of light absorption layer 56, and a transparent, electrically conductive film 59 covering at least a portion of a major surface of first conduction type layer 57 and having an irregular geometry on a side thereof opposite to first conduction type layer 57. Between back surface electrode layer 53 and light absorption layer 56, a second conduction type layer 55 which has a second conduction type opposite to the first conduction type is provided. First conduction type layer 57, light absorption layer 56, and second conduction type layer 55 configure a photoelectric conversion layer 58. The irregular geometry has a bump 51 having a maximum height equal to or larger than 50 nm and equal to or smaller than 1200 nm. Bump 51 has a surface having submicron recesses 54 having local peaks having a spacing equal to or larger than 2 nm and equal to or smaller than 25 nm.

For a CIS-, CIGS-, and other similar, chalcopyrite-based thin film solar cells, a first conduction type semiconductor layer which contains a zinc compound as a main component and a light absorption layer which contains a chalcopyrite based compound as a main component may have an irregular interface therebetween. The irregular geometry may have bumps having a maximum height equal to or larger than 50 nm and equal to or smaller than 1200 nm, and submicron recesses formed on a surface of the bump and having local peaks having a spacing equal to or larger than 2 nm and equal to or smaller than 25 nm.

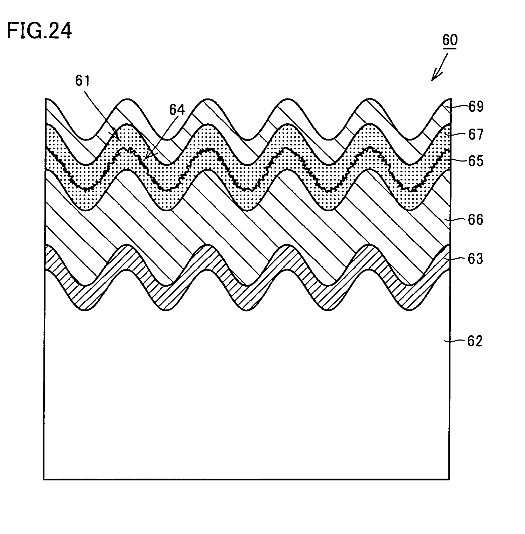

Fig. 24 is a cross section showing a structure of a chalcopyrite based thin film solar cell with the present invention applied thereto. A chalcopyrite based thin film solar cell 60 with the present invention applied thereto as shown in Fig. 24 includes a substrate 62, a back surface electrode layer 63 covering at least a portion of a major surface of substrate 62, a light absorption layer 66 covering at least a portion of a major surface of back surface electrode layer 63, and a first conduction type layer 67 of a first conduction type covering at least a portion of a major surface of light absorption layer 66. A buffer layer 65 is provided between light absorption layer 66 and first conduction type layer 67. First conduction type layer 67 has an irregular geometry at a side thereof opposite to light absorption layer 66. The irregular geometry has a bump 61 having a maximum height equal to or larger than 50 nm and equal to or smaller than 1200 nm. Bump 61 has a surface having submicron recesses 64 having local peaks having a spacing equal to or larger than 2 nm and equal to or smaller than 25 nm.

Furthermore, the "photoelectric conversion device" of the present invention includes not only a manner configured of a substrate, a first electrode layer, a semiconductor layer, and a second electrode layer, as illustrated in the above embodiment by way of example, but also a stack of these layers that is modularized. In other words, if the present invention is applied to a super straight type silicon based thin film solar cell, then, as illustrated in Fig. 24 as a cross section of a thin film solar cell module, it has on a single substrate a transparent, electrically conductive film, a semiconductor layer, and a back surface electrode that are divided into a plurality of portions, mutually, electrically connected in series, and a sealant and a back surface cover disposed to cover the back surface electrode. If necessary, a frame can further be provided on a side surface of the substrate.

It should be understood that the embodiments disclosed herein are illustrative and non-restrictive in any respect. Accordingly the scope of the present invention is not construed only through the above embodiments; rather, it is defined by the claims. Furthermore, it also encompasses any modifications within the scope and meaning equivalent to the terms of the claims.

### REFERENCE SIGNS LIST

1, 30, 40, 50, 60: photoelectric conversion device; 2: glass substrate; 3, 16, 59, 69: transparent, electrically conductive film; 4: substrate for photoelectric conversion device; 5, 28, 29, 35, 45, 55: p layer; 6, 36, 46: i layer; 7, 37, 47: n layer; 8, 38, 48: photoelectric conversion layer; 9, 53, 63: back surface electrode layer; 10, 51, 61: bump; 11, 54, 64: submicron recess; 12: interface; 13, 13A, 13B: rolling circle; 14: center of rolling circle; 15A, 15B: local peak; 17: TCO substrate;18: light; 19, 21, 23: transmitted light; 20, 22: reflected light; 24: hydrogen atom; 25: carbon atom; 26: bottom; 27: defect; 28: silicon atom: 52, 62: substrate; 56, 66: light absorption layer; 57, 67: first conduction type layer; 55: second conduction type layer; 65: buffer layer.

## Claims

1. A substrate for a photoelectric conversion device, comprising:
a substrate (2); and
a transparent, electrically conductive film (3) covering at least a portion of a major surface of said substrate (2) and having an irregular geometry on a surface thereof facing away from said substrate (2),
said irregular geometry having a bump (10) having a maximum height equal to or larger than 50 nm and equal to or smaller than 1200 nm,
said bump (10) having a surface having a submicron recess (11) having local peaks (15A,15B) having a spacing equal to or larger than 2 nm and equal to or smaller than 25 nm.

2. The substrate for a photoelectric conversion device according to claim 1, wherein said submicron recess (11) has a linear density equal to or larger than 0.05 nm⁻¹.

3. The substrate for a photoelectric conversion device according to claim 1, wherein said submicron recess (11) has a maximum depth equal to or larger than 2 nm and equal to or smaller than 10 nm.

4. A photoelectric conversion device comprising:
a substrate (4) for the photoelectric conversion device according to claim 1; and
a semiconductor layer covering at least a portion of said transparent, electrically conductive film (3) included in said substrate (4) for the photoelectric conversion device.

5. The photoelectric conversion device according to claim 4, comprising another semiconductor layer covering said semiconductor layer.

6. A photoelectric conversion device comprising:
a substrate (4) for the photoelectric conversion device according to claim 1;
a first conduction type semiconductor layer (5) having a first conduction type and covering at least a portion of said irregular geometry of said transparent, electrically conductive film (3); and
a light absorption layer (6) covering said first conduction type semiconductor layer (5),
said first conduction type semiconductor layer (5) being larger in thickness on a bottom (26) of said submicron recess (11) than at a portion other than said bottom (26).

7. A photoelectric conversion device comprising:
a substrate (4) for the photoelectric conversion device according to claim 1;
a first conduction type semiconductor layer (5) having a first conduction type and covering at least a portion of said irregular geometry of said transparent, electrically conductive film (3); and
a light absorption layer (6) covering said first conduction type semiconductor layer (5), said first conduction type semiconductor layer and said light absorption layer having their interface with a maximum depth (Bₘₐₓ) smaller than a maximum depth (Dₘₐₓ) of said submicron recess.

8. The photoelectric conversion device according to claim 6, wherein said first conduction type semiconductor layer (5) is equal to or larger than 5 nm and equal to or smaller than 15 nm in thickness.

9. The photoelectric conversion device according to claim 4, wherein said semiconductor layer is configured of one or more types of thin film selected from the group consisting of silicon based thin film and thin film containing CdTe as a main component.

10. A photoelectric conversion device, comprising:
a substrate (52);
a back surface electrode layer (53) covering at least a portion of a major surface of said substrate (52);
a light absorption layer (56) covering at least a portion of a major surface of said back surface electrode layer (53);
a first conduction type layer (57) having a first conduction type and covering at least a portion of a major surface of said light absorption layer (56); and
a transparent, electrically conductive film (59) covering at least a portion of a major surface of said first conduction type layer (57) and having an irregular geometry on a side thereof opposite to said first conduction type layer (57),
said irregular geometry having a bump (51) having a maximum height equal to or larger than 50 nm and equal to or smaller than 1200 nm,
said bump (51) having a surface having a submicron recess (54) having local peaks having a spacing equal to or larger than 2 nm and equal to or smaller than 25 nm.

11. The photoelectric conversion device according to claim 10, wherein said light absorption layer is configured of one or more types of thin film selected from the group consisting of silicon based thin film and thin film containing a chalcopyrite based compound as a main component.

12. A photoelectric conversion device, comprising:
a substrate (62);
a back surface electrode layer (63) covering at least a portion of a major surface of said substrate (62);
a light absorption layer (66) covering at least a portion of a major surface of said back surface electrode layer (63); and
a first conduction type layer (67) having a first conduction type and covering at least a portion of a major surface of said light absorption layer (66),
said first conduction type layer (67) having an irregular geometry on a side thereof opposite to said light absorption layer (66),
said irregular geometry having a bump (61) having a maximum height equal to or larger than 50 nm and equal to or smaller than 1200 nm,
said bump (61) having a surface having a submicron recess (64) having local peaks having a spacing equal to or larger than 2 nm and equal to or smaller than 25 nm.

13. A method for producing a substrate for a photoelectric conversion device, comprising the steps of:
depositing a transparent, electrically conductive film (3) to cover at least a portion of a major surface of a substrate (2), said transparent, electrically conductive film (3) having an irregular geometry having a bump (10) having a maximum height equal to or larger than 50 nm and equal to or smaller than 1200 nm; and
exposing said transparent, electrically conductive film (3) to a hydrogen containing plasma.

14. The method for producing a substrate for a photoelectric conversion device according to claim 13, wherein said hydrogen containing plasma employs a gas formed substantially only of gaseous hydrogen.

15. The method for producing a substrate for a photoelectric conversion device according to claim 13, comprising the step of forming on a surface of said bump (10) a submicron recess (11) having local peaks (15A,15B) having a spacing equal to or larger than 2 nm and equal to or smaller than 25 nm.

16. The method for producing a substrate for a photoelectric conversion device according to claim 15, comprising the step of introducing a defect in a surface of said transparent, electrically conductive film (3) between the step of depositing said transparent, electrically conductive film (3) and the step of forming said submicron recess (11).

17. The method for producing a substrate for a photoelectric conversion device according to claim 15, employing a carbon containing hydrogen plasma in the step of forming said submicron recess (11).

18. A method for producing a photoelectric conversion device, comprising the step of depositing a semiconductor layer to cover at least a portion of said transparent, electrically conductive film (3) included in a substrate (4) for a photoelectric conversion device produced in the method for producing a substrate for a photoelectric conversion device according to claim 15.

19. The method for producing a photoelectric conversion device according to claim 15, comprising the steps of:
depositing a first conduction type semiconductor layer (5) to cover at least a portion of said transparent, electrically conductive film (3); and
depositing a light absorption layer (6) to cover said first conduction type semiconductor layer (5), wherein in the step of depositing said first conduction type semiconductor layer (5), said first conduction type semiconductor layer (5) is formed to be larger in thickness on a bottom (26) of said submicron recess (11) than at a portion other than said bottom (26).

20. The method for producing a photoelectric conversion device according to claim 15, comprising the steps of:
depositing a first conduction type semiconductor layer (5) to cover at least a portion of said transparent, electrically conductive film (3); and
depositing a light absorption layer (6) to cover said first conduction type semiconductor layer (5), wherein in the step of depositing said first conduction type semiconductor layer (5), said first conduction type semiconductor layer (5) is formed so that said first conduction type semiconductor layer (5) and said light absorption layer (6) have an interface therebetween with a maximum depth (Bₘₐₓ) smaller than a maximum depth (Dₘₐₓ) of said submicron recess.

21. The method for producing a photoelectric conversion device according to claim 19, forming said submicron recess (11) to have a maximum depth equal to or larger than 2 nm and equal to or smaller than 10 nm.

22. The method for producing a photoelectric conversion device according to claim 19, forming said submicron recess (11) to have a linear density equal to or larger than 0.05 nm⁻¹.
